# EUROPEAN PATENT APPLICATION

(11) **EP 4 362 070 A1**
(43) Date of publication of application: **01.05.2024**
(21) Application number: 23206784.3
(22) Date of filing: 30.10.2023
(51) Int. Cl.: H01L 21/56, H01L 23/31, H01L 23/373, H01L 23/433, H01L 23/495

(54) **SEMICONDUCTOR PACKAGE WITH MOLDED HEAT DISSIPATION PLATE**

(30) Priority: 31.10.2022 US 202217977640
(71) Applicant: Infineon Technologies Austria AG, 9500 Villach (AT)
(72) Inventor: SON, Joon Seo, 04355 Seoul (KR); JONG, Man Kyo, 14583, Bucheon-si (KR)
(74) Representative: Lambsdorff & Lange Patentanwälte Partnerschaft mbB

(57) **Abstract**

A method of producing a semiconductor package includes providing a molded plate that is formed of a first mold compound, providing a lead frame assembly that includes a lead frame and a semiconductor die mounted on a die pad of the lead frame, arranging the lead frame assembly and the molded plate within a molding chamber of a molding tool such that the molded plate is interposed between the die pad and an interior surface of the molding chamber, and performing a molding process that fills the molding chamber with a second mold compound that encapsulates the semiconductor die.

## Description

### BACKGROUND

Many different applications such as automotive and industrial applications utilize power modules that comprise multiple power devices in a single package or housing. Power modules may include power conversion circuits such as single and multi-phase half-wave rectifiers, single and multi-phase full-wave rectifiers, voltage regulators, inverters, etc. Power modules can form part of power efficient solutions to reduce or prevent anthropogenic emissions of greenhouse gases. For instance, hybrid electric vehicles (HEVs) or electric vehicles (EVs) utilize power modules to perform power conversion, inversion, switching, etc., in a power efficient manner. There is a desire to manufacture power modules at lower cost.

### SUMMARY

Those skilled in the art will recognize additional features and advantages upon reading the following detailed description, and upon viewing the accompanying drawings.

A method of producing a semiconductor package is disclosed. According to an embodiment, the method comprises providing a molded plate that is formed of a first mold compound, providing a lead frame assembly that comprises a lead frame and a semiconductor die mounted on a die pad of the lead frame, arranging the lead frame assembly and the molded plate within a molding chamber of a molding tool such that the molded plate is interposed between the die pad and an interior surface of the molding chamber, and performing a molding process that fills the molding chamber with a second mold compound that encapsulates the semiconductor die.

A semiconductor package is disclosed. According to an embodiment, the semiconductor package comprises a lead frame comprising a die pad and a plurality of leads extending away from the lead frame, a semiconductor die mounted on the die pad and electrically connected to the leads, and an electrically insulating package body that encapsulates the semiconductor die and exposes outer ends of the leads, wherein the electrically insulating package body comprises a molded plate that is formed of a first mold compound and a region of second mold compound that surrounds the molded plate, wherein the electrically insulating package body comprises a mounting surface that is spaced apart from a rear side of the die pad, and wherein the molded plate forms a direct path of the first mold compound between the rear side of the die pad and the mounting surface.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
Figure 1 illustrates an assembly of a semiconductor package mated with a heat sink, according to an embodiment.
Figure 2, which includes Figs. 2A, 2B, 2C, and 2D, illustrates a method of forming a semiconductor package, according to an embodiment. Fig. 2A illustrates providing a lead frame assembly; Fig. 2B illustrates arranging the lead frame assembly and a molded plate within a molding chamber; Fig. 2C illustrates flowing liquified mold compound into the molding chamber; and Fig. 2D illustrates the molding chamber being completely filled.
Figure 3 illustrates a semiconductor package, according to an embodiment.

### DETAILED DESCRIPTION

Embodiments of a method of producing a semiconductor package and a corresponding semiconductor package are described herein. The method comprises using a molded plate to form part of the package body that encapsulates the semiconductor die and lead frame. The molded plate is provided between the die pad and an outer mounting surface of the package body. The molded plate thus provides a thermal conduction path between the die pad and the outer mounting surface of the package body. The semiconductor package is formed by providing the molded plate as a pre-formed structure before the molding process. An assembled lead frame is arranged together with the molded plate within a molding chamber and a liquified mold compound is provided within the molding chamber around the lead frame assembly and the molded plate. This technique allows for a reduced thickness of mold material between the die pad and the outer mounting surface of the package body. Moreover, this technique allows for the provision of two different mold materials in the package body with different characteristics, e.g., thermal conductivity, dielectric constant, cost, etc. As a result, there is no need to make unwanted tradeoffs between competing design considerations for the thermally active part of the package body and the surrounding part of the package body.

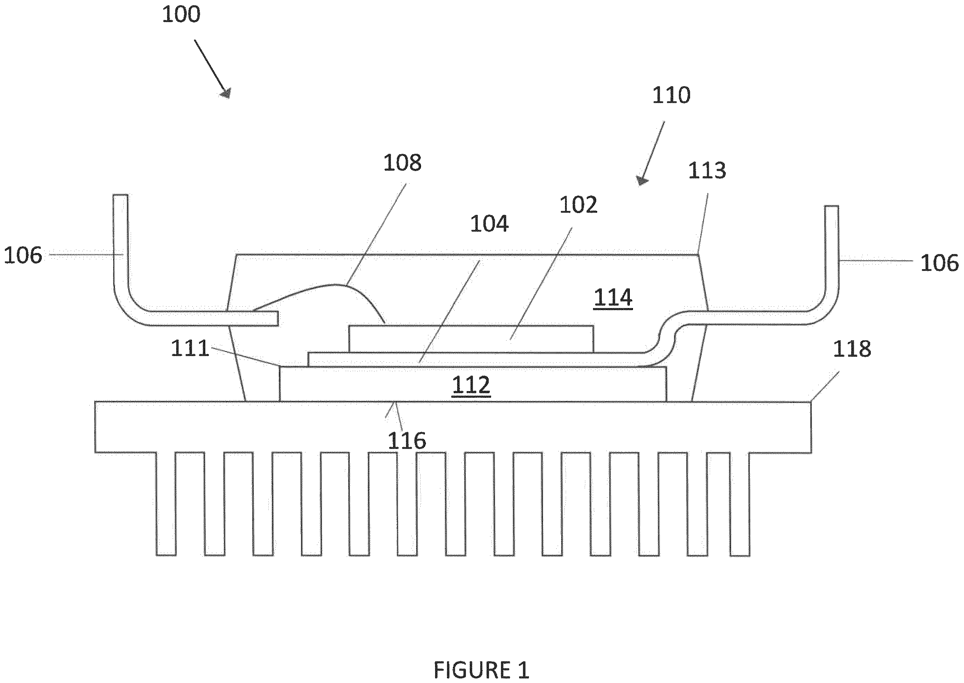

Referring to Figure 1, a semiconductor package 100 is depicted, according to an embodiment. The semiconductor package 100 comprises a semiconductor die 102. The semiconductor die 102 can comprise any of a wide variety of semiconductor materials including but not limited to elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AlInN), indium gallium nitride (InGaN), aluminum. The semiconductor die 102 can have wide variety of device configurations including integrated device configurations and discrete device configurations. The semiconductor die 102 may be configured as a vertical device, which refers to a device that conducts a load current between opposite facing main and rear surfaces of the die. Alternatively, the semiconductor die 102 may be configured as a lateral device, which refers to a device that conducts a load current parallel to a main surface of the die.

According to an embodiment, the semiconductor die 102 is configured as a discrete power device. A discrete power device refers to a discrete component, e.g., transistor, diode, thyristor, etc., that is rated to control large voltages and currents, e.g., voltages of at least 100 V (volts), and more typically voltages of 600 V, 1200 V or more and/or currents of least 1A, and more typically currents of 10A, 50A, 100A or more. In a particular example, the semiconductor die 102 is configured as a discrete power transistor die, for example a MOSFET (Metal Oxide Semiconductor Field Effect Transistor), an IGBT (Insulated Gate Bipolar Transistor), or a HEMT (High Electron Mobility Transistor).

The semiconductor package 100 comprises a lead frame that comprises a die pad 104 and a plurality of leads 106. The lead frame is a metal structure formed from electrically conductive metals such as copper, nickel, aluminum, palladium, gold, and alloys or combinations thereof. The semiconductor die 102 is mounted on the die pad 104. In the case of a vertical device, an electrical connection may be provided between a rear side terminal, e.g., source, drain, collector, emitter, etc. of the semiconductor die 102 and the die pad 104, which in turn may be continuously connected to one of the leads 106 (as shown). Alternatively, the die pad 104 can be separated from each of the leads 106, e.g., in the case of a lateral device. Upper side terminals of the semiconductor die 102 are electrically connected to the leads 106 by electrical interconnect elements. As shown, the semiconductor package 100 comprises a bond wire 108 connecting the upper side terminals of the semiconductor die 102, e.g., gate, source, drain, collector, and the leads 106. Other types of electrical interconnect elements such as clips, ribbons, etc. may be used to effectuate these electrical connections.

The semiconductor package 100 comprises an electrically insulating package body 110. The electrically insulating package body 110 encapsulates the semiconductor die 102, i.e., surrounds and protects the semiconductor die 102 and electrical connections thereto. Outer ends of the leads 106 are exposed from the package body 110 and thus provide externally accessible points of electrical contact. The lead configuration of the semiconductor package 100 may vary from what is shown. For example, the semiconductor package 100 may be configured as a so-called leadless package, a so-called surface mount package, etc.

The electrically insulating package body 110 comprises a molded plate 111 that is formed of a first mold compound 112 and a region 113 of second mold compound 114 that surrounds the molded plate 111. As will be explained in further detail below, the molded plate 111 is formed by a first molding process that is performed at a different time as a second molding process that forms the region 113 of second mold compound 114. The first and second mold compounds 112, 114 may each comprise an epoxy-based mold compound. The first and second mold compounds 112, 114 may comprise a matrix that comprises one or more of: epoxy resin, polyimide, poly bismaleimide, silicone, benzoxazine, phenol derivate, cyanate ester or materials from the hydroxyl group, for example. The first and second mold compounds 112, 114 may also comprise filler particles suspended in the matrix, e.g., particles of SiO₂, Al₂O₃, Si₃N₄, BN, AlN, diamond, etc. The size of the filler particles may be in a range between 1 nm and 200 µm, in particular in a range between 10 nm and 20 µm, more particularly in a range between 2 µm and 5 µm. The first and second mold compounds 112, 114 may also comprise a curing agent, e.g., amines, acids, acid anhydrides, phenols, alcohols and thiols, for example.

The electrically insulating package body 110 comprises a mounting surface 116 that is spaced apart from a rear side of the die pad 104. The mounting surface 116 is arranged such that the semiconductor package 100 can be mated with a planar receiving surface of a heat sink 118. In this way, heat generated by the semiconductor die 102 during operation can be extracted via the heat sink 118. Meanwhile, the side of the semiconductor package 100 opposite from the mounting surface 116 can be mated with a circuit carrier, such as a PCB (printed circuit board) with the leads 106 facing and electrically connected to the circuit carrier.

The electrically insulating package body 110 is configured such that the molded plate 111 forms at least part of the mounting surface 116. As shown, an outer surface of the molded plate 111 is coplanar with a surface from the region 113 of second mold compound 114 and these surfaces together form the mounting surface 116. In other embodiments, the molded plate 111 may protrude from the region 113 of second mold compound 114 and/or form the exclusive mounting surface 116 of the electrically insulating package body 110.

The molded plate 111 forms a direct path of the first mold compound 112 between the rear side of the die pad 104 and the mounting surface 116. That is, the molded plate 111 provides a region of the first mold compound 112 that extends from the rear side of the die pad 104 to the mounting surface 116. In this way, the heat generated by the semiconductor die 102 is primarily transferred to the heat sink 118 via the first mold compound 112.

According to an embodiment, the first mold compound 112 that forms the molded plate 111 has a different composition than the second mold compound 114 which forms the region 113 of second mold compound 114. This difference in composition can be attributable to any difference in the constituent components of the first and second mold compounds 112, 114 and/or the mixing ratio, i.e., molar fractions of the constituent components. For example, the first and second mold compounds 112, 114 may comprise a different matrix material and/or curing agent. Separately or in combination, the first and second mold compounds 112, 114 may comprise a difference in the filler particles. For example, the first mold compound 112 may comprise filler particles whereas the second mold compound 114 does not comprise filler particles, or vice-versa. Alternatively, the first and second mold compounds 112, 114 may comprise different combinations of filler particles. According to an embodiment, the first mold compound 112 comprises at least one filler particle that is not present in the second mold compound 114. This filler particle or particles may comprise any one more of: SiO₂, Al₂O₃, Si₃N₄ particle, BN, or AlN, for example.

As a result of the different composition of the first and second mold compounds 112, 114, the molded plate 111 and the region 113 of second mold compound 114 may have different properties, e.g., thermomechanical properties, electrical properties, etc. For example, according to an embodiment, the first mold compound 112 has a higher thermal conductivity than the second mold compound 114. Separately or in combination, according to an embodiment, the first mold compound 112 has a higher dielectric constant than the second mold compound 114. Separately or in combination, according to an embodiment, the first mold compound 112 has a different melting point than the second mold compound 114.

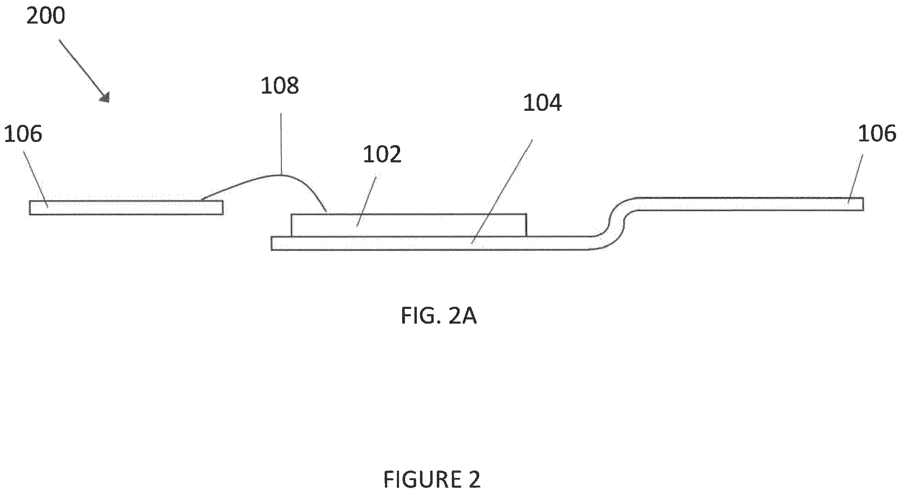

Referring to Fig. 2A, a method of producing the semiconductor package 100 comprises providing a lead frame assembly 200. The lead frame assembly 200 comprises a lead frame, which in turn comprises a die pad 104 and a plurality of leads 106 extending away from the lead frame. The lead frame can be provided from a substantially uniform thickness sheet of metal and the geometric features of the die pad 104 and the leads 106 can be created by metal processing techniques, e.g., stamping, punching, etching, etc. The lead frame assembly 200 further comprises a semiconductor die 102 mounted on the die pad 104. This can be done using an attachment material, e.g., solder, sinter, glue, etc. The lead frame assembly 200 further comprises the bond wires 108 (as shown) or other type of electrical interconnect elements connecting the upper side terminals of the semiconductor die 102 to the leads 106.

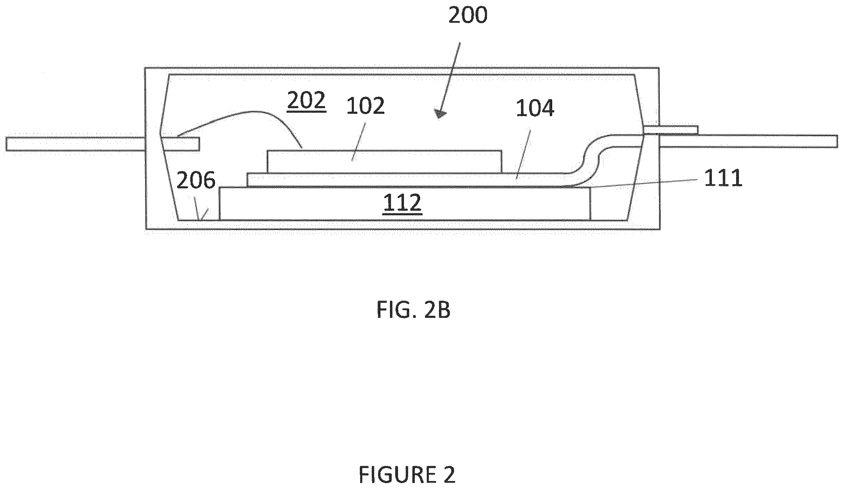

Referring to Fig. 2B, the lead frame assembly 200 and the molded plate 111 are arranged within a molding chamber 202 of a molding tool. The molding chamber 202 is a three-dimensional space that is used to define the geometry of the electrically insulating package body 110. The molding chamber 202 may have a variety of different chamber constructions e.g., hot runner, cold runner, single cavity, multi-cavity, two plate, three plate.

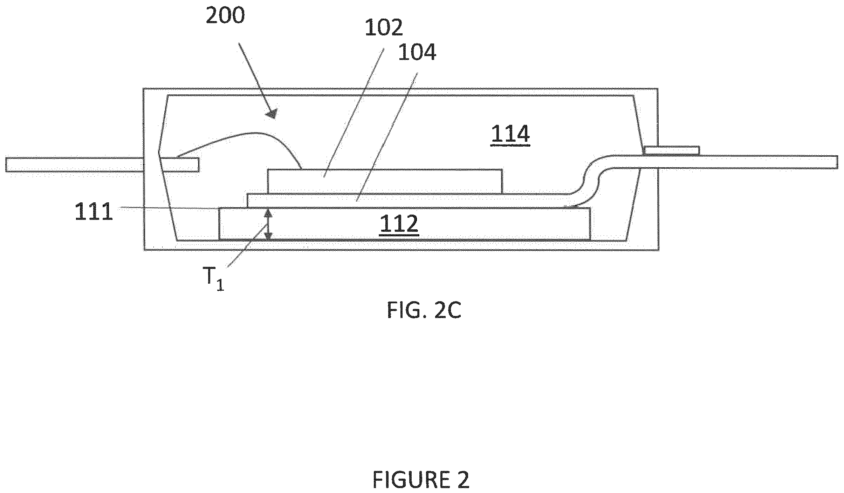

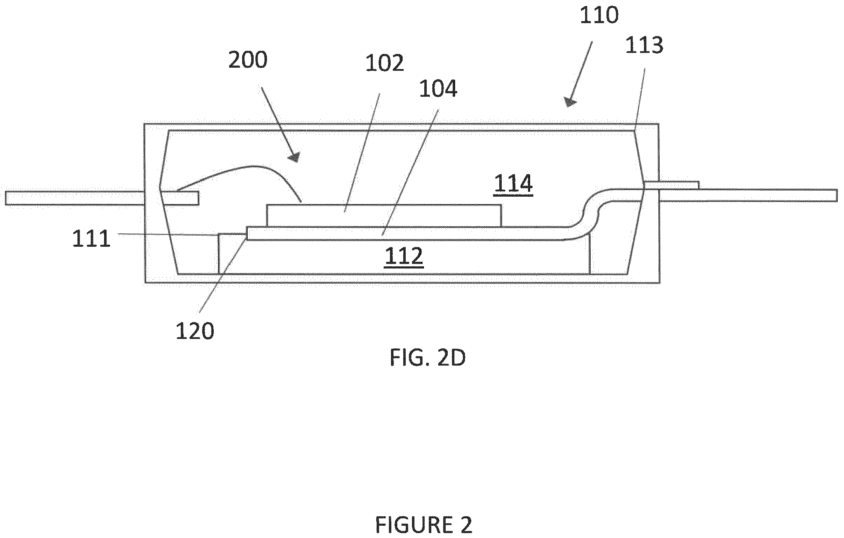

The molded plate 111 is a pre-fabricated component that is formed by a separate molding process as the molding process of Figure 2. The molded plate 111 can be formed by any molding technique, e.g., injection molding, compression molding, 3D printing, etc. The molded plate 111 can be formed by a separate entity or the same entity as the entity that performs the molding process of Figure 2. The molded plate 111 is arranged such that it is interposed between the die pad 104 and an interior surface 206 of the molding chamber 202. This may be done by initially placing the molded plate 111 on the interior surface 206 of the molding chamber and subsequently placing the lead frame assembly 200 thereon. Alternatively, the molded plate 111 may be initially adhered to the die pad 104 and the combined structure can be placed in the molding chamber 202 at once.

Referring to Fig. 2C, a molding process is performed with the lead frame assembly 200 and the molded plate 111 arranged within the molding chamber 202. The molding process provides a liquified state version of the second mold compound 114 into the molding chamber 202. The second molding compound 114 forms around the lead frame assembly 200 and the molded plate 111. As shown, the molding process is a transfer molding process whereby second molding compound 114 is pushed into the molding chamber 202 from an external reserve (not shown). More generally, the semiconductor package 100 disclosed herein can be provided by any type of molding process that involves using heat and/or pressure to liquefy and form a molding compound. These molding processes include any type of injection molding technique or compression molding technique, for example.

According to an embodiment, the thickness T₁ of the molded plate 111 is no greater than 400 µm. For example, the thickness T₁ of the molded plate 111 may be between 100 µm and 400 µm. A thickness value of no greater than 400 µm may be advantageous with respect to thermal dissipation, as the amount of mold compound arranged between the die pad 102 and the heat sink 118 (see Figure 1) can be reduced. However, molding techniques are limited in their ability to reliably create low thicknesses regions of mold compound, due to the need for an open passage for liquified mold material to flow unimpeded. In particular, it may be difficult or impossible to form a layer of mold material between a die pad and an outer surface of a package body to be 400 µm or less by flowing liquified mold material using an injection molding process. The molded plate 111 advantageously eliminates the need to flow a liquified mold compound in a narrow space between the die pad 102 and the interior surface 206 of the molding chamber 202.

Referring to Fig. 2D, the molding process completely fills the molding chamber 202 with the second mold compound 114, thus forming the electrically insulating package body 110 in the desired shape. After the liquified second mold compound 114 hardens, a lead trimming process can be performed to detach the individual leads 106 from one another and provide a discrete semiconductor package 100.

According to an embodiment, the molded plate 111 partially liquefies during the molding process such that one or more edge sides 120 of the die pad 104 become embedded within the first mold compound 112 of the molded plate 111. In this context, the term partially liquefy means that the first mold compound 112 has viscous properties to slightly deform without intermixing with the second mold compound 114, e.g., a viscosity in the range of 10,000 - 250,000 cP (centipoise), such that the essential structure of the molded plate 111 remains intact. The molded plate 111 may partially liquefy from contact with the heated second mold compound 114 itself and/or from ambient temperatures that are used to liquefy the second mold compound 114. As mentioned above, the composition of the first mold compound 112 can be selected to have a higher melting point than the second mold compound 114, thus providing a discrepancy in the viscosity of the first and second mold compounds 112, 114 under the same molding conditions. One benefit of the edge sides 120 becoming embedded within the first mold compound 112 is enhanced adhesion and prevention of slippage during subsequent processing such as lead trimming.

By providing the molded plate 111 separately from the second mold compound 114, an advantageous bifurcation of the characteristics of the electrically insulating package body 110 is possible. For example, the composition of the molded plate 111 can be selected for performance with respect to thermal dissipation and/or electrical isolation, whereas the composition of the second mold compound 114 can be selected based on other considerations, such as cost and/or mold flowability. However, the first and second mold compounds 112, 114 can also be compositionally similar or identical, and some of the above-described benefits may be realized. For example, a low thickness region of less than 400 µm underneath the die pad 104 may be obtained, and edge sides 120 of the die pad 104 may become embedded within the first mold compound 112 of the molded plate 111 using the same mold compounds.

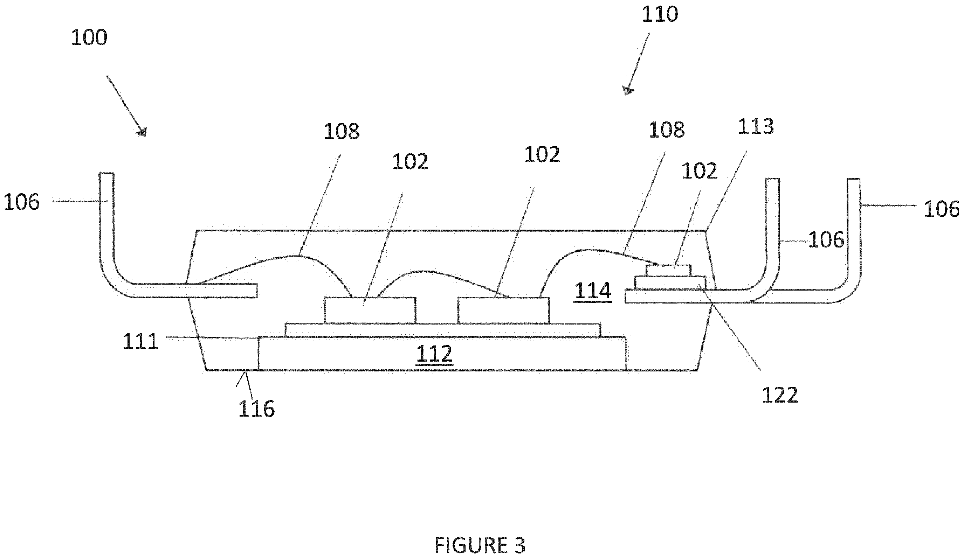

Referring to Figure 3, a semiconductor package 100 is depicted, according to an embodiment. The semiconductor package 100 of Figure 3 comprises the molded plate 111 which forms a direct path of the first mold compound 112 between the rear side of the die pad 104 and the mounting surface 116 in a similar manner as described above. In this embodiment, the semiconductor package 100 is configured as an intelligent power module (IPM). An intelligent power module refers to an integrated package that comprises at least one power switching device, e.g., IGBT, MOSFET, HEMT, etc., and a control device that controls a switching operation of the power switching device. For example, an intelligent power module may comprise one or more half-bridge circuits and a driver die that is configured to control the half-bridge circuit according to a control scheme, e.g., pulse width modulation (PWM). As shown, the semiconductor package 100 comprises a pair of semiconductor dies 102 mounted on the die pad 104, which may correspond to the high-side switch and the low-side switch of a half-bridge circuit. The semiconductor package 100 additionally comprises a circuit board 122 with a semiconductor die 102, which may correspond to a controller die that is configured to control the switching of the half-bridge circuit.

Although the present disclosure is not so limited, the following numbered examples demonstrate one or more aspects of the disclosure.

Example 1. A method of producing a semiconductor package, the method comprising: providing a molded plate that is formed of a first mold compound; providing a lead frame assembly that comprises a lead frame and a semiconductor die mounted on a die pad of the lead frame; arranging the lead frame assembly and the molded plate within a molding chamber of a molding tool such that the molded plate is interposed between the die pad and an interior surface of the molding chamber; and performing a molding process that fills the molding chamber with a second mold compound that encapsulates the semiconductor die.

Example 2. The method of example 1, wherein the molding process forms an electrically insulating package body comprising the molded plate and a region of the second mold compound, wherein the electrically insulating package body comprises a mounting surface that is spaced apart from a rear side of the die pad, and wherein the molded plate forms a direct path of the first mold compound between the rear side of the die pad and the mounting surface.

Example 3. The method of example 2, wherein the mounting surface comprises an outer surface of the molded plate that is coplanar with a surface of the region of the second mold compound.

Example 4. The method of example 1, wherein the first mold compound has a different composition as the second mold compound.

Example 5. The method of example 4, wherein the first mold compound has a higher thermal conductivity than the second mold compound.

Example 6. The method of example 4, wherein the first mold compound has a higher dielectric constant than the second mold compound.

Example 7. The method of example 4, wherein the first mold compound comprises at least one filler particle that is not present in the second mold compound.

Example 8. The method of example 7, wherein the at least one filler particle that is not present in the second mold compound comprises any one or more of: SiO2; Al2O3; AlN; and BN.

Example 9. The method of example 1, wherein during the molding process the molded plate partially liquefies such that an edge side of the die pad becomes embedded within the first mold compound.

Example 10. The method of example 1, wherein a thickness of the molded plate is between 100 µm and 400 µm.

Example 11. A semiconductor package, comprising: a lead frame comprising a die pad and a plurality of leads extending away from the lead frame; a semiconductor die mounted on the die pad and electrically connected to the leads; and an electrically insulating package body that encapsulates the semiconductor die and exposes outer ends of the leads, wherein the electrically insulating package body comprises a molded plate that is formed of a first mold compound and a region of second mold compound that surrounds the molded plate, wherein the electrically insulating package body comprises a mounting surface that is spaced apart from a rear side of the die pad, and wherein the molded plate forms a direct path of the first mold compound between the rear side of the die pad and the mounting surface.

Example 12. The semiconductor package of example 11, wherein the mounting surface comprises an outer surface of the molded plate that is coplanar with a surface of the region of the second mold compound.

Example 13. The semiconductor package of example 11, wherein the first mold compound has a different composition as the second mold compound.

Example 14. The semiconductor package of example 13, wherein the first mold compound has a higher thermal conductivity than the second mold compound.

Example 15. The semiconductor package of example 13, wherein the first mold compound has a higher dielectric constant than the second mold compound.

Example 16. The semiconductor package of example 13, wherein the first mold compound comprises at least one filler particle that is not present in the second mold compound.

Example 17. The semiconductor package of example 16, wherein the at least one filler particle that is not present in the second mold compound comprises any one or more of: SiO2; Al2O3; AlN; and BN.

Example 18. The semiconductor package of example 11, wherein a thickness of the molded plate is between 100 µm and 400 µm.

Example 19. The semiconductor package of example 11, wherein the semiconductor die is a power transistor die.

Example 20. The semiconductor package of example 19, wherein the semiconductor package is configured as an intelligent power module.

In the context of the present application, the term "polymer resin" may particularly denote a substance made of molecules being composed of a plurality of repeated subunits. Polymers are created by polymerization of multiple smaller molecules (which may be denoted as monomers). Polymerization may denote a process of reacting monomer molecules together in a chemical reaction to form polymer chains or three-dimensional networks.

In the context of the present application, the term "curing agent" may particularly denote a substance capable of triggering or promoting curing (in particular hardening) of the polymer resin, in particular by cross-linking of polymer chains thereof. Curing agents can react with epoxy resin via nucleophilic attach of the oxiran in an equimolar way and also can be scaled down to lower molarity, as the epoxy function can also react with itself. With the ratio between epoxy resin and hardener therefore the copolymer chain sequence can be modified, and hence the mechanical and chemical properties.

In the context of the present application, the term "matrix" may particularly denote a basic material constituted by free adhesion promoter and polymer resin and curing agent and catalyst, within which the remaining constituent(s) of the mold compound may be mixed. In other words, the matrix may be a substance in which the other constituent(s) of the mold compound is or are embedded.

In the context of the present application, the term "filler" may particularly denote a (in particular powderous or granulate-type) substance filling out interior volumes in the matrix. By the selection of the filler, the physical and/or chemical properties of the mold compound can be adjusted. Such properties may include the coefficient of thermal expansion, the thermal conductivity, the dielectric properties, etc.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method of producing a semiconductor package, the method comprising:
providing a molded plate that is formed of a first mold compound;
providing a lead frame assembly that comprises a lead frame and a semiconductor die mounted on a die pad of the lead frame;
arranging the lead frame assembly and the molded plate within a molding chamber of a molding tool such that the molded plate is interposed between the die pad and an interior surface of the molding chamber; and
performing a molding process that fills the molding chamber with a second mold compound that encapsulates the semiconductor die.

2. The method of claim 1, wherein the molding process forms an electrically insulating package body comprising the molded plate and a region of the second mold compound, wherein the electrically insulating package body comprises a mounting surface that is spaced apart from a rear side of the die pad, and wherein the molded plate forms a direct path of the first mold compound between the rear side of the die pad and the mounting surface.

3. The method of claim 2, wherein the mounting surface comprises an outer surface of the molded plate that is coplanar with a surface of the region of the second mold compound.

4. The method of any one of the preceding claims, wherein the first mold compound has a different composition as the second mold compound.

5. The method of claim 4, wherein the first mold compound has a higher thermal conductivity than the second mold compound.

6. The method of claim 4 or 5, wherein the first mold compound has a higher dielectric constant than the second mold compound.

7. The method of any one of claims 4 to 6, wherein the first mold compound comprises at least one filler particle that is not present in the second mold compound.

8. The method of claim 7, wherein the at least one filler particle that is not present in the second mold compound comprises any one or more of:
SiO_{2;}
Al₂O_{3;}
AlN; and
BN.

9. The method of any one of the preceding claims, wherein during the molding process the molded plate partially liquefies such that an edge side of the die pad becomes embedded within the first mold compound.

10. The method of any one of the preceding claims, wherein a thickness of the molded plate is between 100 µm and 400 µm.

11. A semiconductor package, comprising:
a lead frame comprising a die pad and a plurality of leads extending away from the lead frame;
a semiconductor die mounted on the die pad and electrically connected to the leads; and
an electrically insulating package body that encapsulates the semiconductor die and exposes outer ends of the leads,
wherein the electrically insulating package body comprises a molded plate that is formed of a first mold compound and a region of second mold compound that surrounds the molded plate,
wherein the electrically insulating package body comprises a mounting surface that is spaced apart from a rear side of the die pad, and
wherein the molded plate forms a direct path of the first mold compound between the rear side of the die pad and the mounting surface.

12. The semiconductor package of claim 11, wherein the mounting surface comprises an outer surface of the molded plate that is coplanar with a surface of the region of the second mold compound.

13. The semiconductor package of claim 11 or 12, wherein the first mold compound has a different composition as the second mold compound.

14. The semiconductor package of claim 13, wherein the first mold compound has a higher thermal conductivity than the second mold compound.

15. The semiconductor package of claim 13 or 14, wherein the first mold compound has a higher dielectric constant than the second mold compound.

16. The semiconductor package of any one of claims 13 to 15, wherein the first mold compound comprises at least one filler particle that is not present in the second mold compound.

17. The semiconductor package of claim 16, wherein the at least one filler particle that is not present in the second mold compound comprises any one or more of:
SiO_{2;}
Al₂O_{3;}
AlN; and
BN.

18. The semiconductor package of any one of claims 11 to 17, wherein a thickness of the molded plate is between 100 µm and 400 µm.

19. The semiconductor package of any one of claims 11 to 18, wherein the semiconductor die is a power transistor die.

20. The semiconductor package of claim 19, wherein the semiconductor package is configured as an intelligent power module.
